# EUROPEAN PATENT APPLICATION

(11) **EP 1 845 625 A2**
(43) Date of publication of application: **17.10.2007**
(21) Application number: 07105547.9
(22) Date of filing: 03.04.2007
(51) Int. Cl.: H04B 1/26

(54) **Double conversion receiver**

(30) Priority: 10.04.2006 KR 20060032319
(71) Applicant: Integrant Technologies Inc., Seongnam-si, Gyoenggi-do 463-810 (KR)
(72) Inventor: Kim, Bonkee, Gyeonggi-do (KR); Cho, Youngho, Gyeonggi-do (KR); Kim, Bo-Eun, Gyeonngi-do (KR)
(74) Representative: Kastel, Stefan

(57) **Abstract**

Provided is a double conversion receiver. The double conversion receiver comprises a direct down-converter down converting a radio frequency (RF) signal at a RF band into a zero-intermediate frequency (IF) signal at a zero-IF band, and an intermediate up-converter up converting the down-converted zero-IF signal into a low-IF signal at a low-IF band.

## Description

This application claims priority on Patent Application No. 10-2006-0032319 filed in Korea on April 10, 2006, the entire contents of which are hereby incorporated by reference.

### BACKGROUND OF THE INVENTION

### Field of the Invention

The present invention relates to a double conversion receiver, and more particularly, to a receiver that converts a received frequency twice.

### Description of the Background Art

A conventional receiver uses a super-heterodyne mode that converts a signal at a radio frequency (RF) band that is received at the receiver into a signal at an intermediate frequency (IF) band and then into a signal at a baseband.

Due to the repeated frequency conversions performed in the receiver using the super-heterodyne mode, a nonlinear characteristic appears, and thus, intermodulation distortions, and parasitic components may be generated in the receiver. Thus, the receiver uses a surface acoustic wave (SAW) filter disposed outside the receiver to remove the intermodulation distortions and the parasitic components, and consequently, the manufacturing cost often increases.

In order to overcome such a limitation, a conventional receiver using a low IF mode has been introduced. The receiver using the low IF mode uses an image rejection filter to remove an image. However, it is generally difficult to completely remove the image using the image rejection filter since an image frequency is generated around the RF band. Thus, the sensitivity of the receiver may deteriorate, and an image band limitation may arise due to a discordance of the in-phase and the quadrature-phase (I/Q).

Therefore, another conventional receiver called a direct conversion receiver or zero-IF receiver is introduced to overcome the above limitations. The direct conversion receiver reduced the number of oscillators into one. Thus, the direct conversion receiver can demodulates a signal at a baseband without converting a RF signal at a RF band into an IF signal at an IF band. As a result, the direct conversion receiver can be integrated into a single chip, and this single chip integration results in miniaturization of the receiver and a simplified manufacturing process.

However, a signal output from the direct conversion receiver (i.e., zero-IF receiver) is usually required to match with an input band at a demodulator.

Accordingly, since demodulators have different input frequency bands, frequency bands output from the direct conversion receiver need to be changed compatible to the individual demodulators.

The above-described receiver receives a signal mixed with a noise signal through an antenna of a terrestrial-digital multimedia broadcasting (T-DMB) or a digital audio broadcasting (DAB) receiver. A degree of attenuation of the signal may differ according to a channel through which the signal is supplied.

Thus, an automatic gain controller (AGC) is used to control the received signal to maintain a uniform magnitude.

However, for a signal at a certain frequency band, an information contained signal section is not often consecutive, and an information contained section and a null section that does not contain information coexist. The magnitude of the signal at the null section is usually smaller than that at the information contained section.

Thus, if the AGC operates at the null section, the amplification gain of an amplifier at the null section increases. The increased amplification gain is often maintained even at the information contained section for a certain period after the null section. As a result, it is often difficult to uniformly maintain the magnitude of the signal at the received information contained section.

### SUMMARY OF THE INVENTION

Accordingly, one embodiment of the present invention is directed to provide a double conversion receiver that can easily select a channel without a SAW filter, be miniaturized, consume less power and make interface at various standard frequency bands.

Another embodiment of the present invention is directed to provide a double conversion receiver that can maintain the magnitude of a received RF signal consistent.

A double conversion receiver according to an embodiment of the present invention comprises a direct down-converter down converting a radio frequency (RF) signal at a RF band into a zero-intermediate frequency (IF) signal at a zero-IF band, and an intermediate up-converter up converting the down-converted zero-IF signal into a low-IF signal at a low-IF band.

Consistent with the embodiment of the present embodiment, the direct down-converter may comprise a low noise amplifier amplifying the RF signal, a down-conversion mixer down converting the amplified RF signal into a zero-IF signal at a zero-IF band, a down-frequency oscillator generating a frequency for the down-conversion and supplying the frequency to the down-conversion mixer, and a filter filtering the zero-IF signal output from the down-conversion mixer. The intermediate up-converter may comprise an up-conversion mixer up converting the zero-IF signal output from the filter into the low-IF signal at the low-IF band, and an up-frequency oscillator generating a frequency for the up-conversion and providing the frequency to the up-conversion mixer.

Consistent with the embodiment of the present invention, the filter may comprise a low pass filter filtering a low frequency band of the zero-IF signal output from the down-conversion mixer, and a variable gain amplifier amplifying the zero-IF signal output from the low pass filter.

Consistent with the embodiment of the present invention, the double conversion receiver may further comprise an automatic gain controller controlling amplification gains of the low noise amplifier and the variable gain amplifier. The automatic gain controller may supply a gain control signal to the low noise amplifier and the variable gain amplifier according to the magnitude of the RF signal. The gain control signal may be controlled by a null control signal based on a null signal comprised in the RF signal.

Consistent with the embodiment of the present invention, the null control signal may control the gain control signal to have a consistent signal level at a null signal section of the RF signal.

Consistent with the embodiment of the present invention, the signal level may be a signal level of the gain control signal before the null signal is received.

Consistent with the embodiment of the present invention, the direct down-converter may comprise a low noise amplifier amplifying the RF signal, an in-phase down-conversion mixer down converting the amplified RF signal into a zero-IF signal at a zero-IF band of an 1-channel, a quadrature-phase down-conversion mixer down converting the amplified RF signal into a zero-IF signal at a zero-IF band of a Q-channel, a down-frequency oscillator generating an in-phase frequency and a quadrature-phase frequency for the down-conversion and supplying the in-phase frequency and the quadrature-phase frequency to the in-phase down-conversion mixer and the quadrature-phase down-conversion mixer, respectively, an in-phase filter filtering the in-phase zero-IF signal at the zero-IF band of the I-channel output from the in-phase down-conversion mixer, and a quadrature-phase filter filtering the quadrature-phase zero-IF signal at the zero-IF band of the Q-channel output from the quadrature-phase down-conversion mixer. The intermediate up-converter may comprise an in-phase up-conversion mixer up converting the filtered in-phase zero-IF signal at the zero-IF band of the I-channel into the low-IF signal at the low-IF band, a quadrature-phase up-conversion mixer up converting the filtered quadrature-phase zero-IF signal at the zero-IF band of the Q-channel into the low-IF signal at the low-IF band, and an up-frequency oscillator generating a frequency for the up-conversion and supplying the frequency to the up-conversion mixer.

Consistent with the embodiment of the present invention, the in-phase filter may comprise an in-phase low pass filter filtering a low frequency band of the zero-IF signal output from the in-phase down-conversion mixer, and an in-phase amplifier amplifying the in-phase zero-IF signal output from the in-phase low pass filter. The quadrature-phase filter may comprise a quadrature-phase low pass filter filtering a low frequency band of the zero-IF signal output from the quadrature-phase down-conversion mixer, and a quadrature-phase amplifier amplifying the quadrature-phase zero-IF signal output from the quadrature-phase low pass filter.

Consistent with the embodiment of the present invention, the double conversion receiver may further comprise an automatic gain controller controlling amplification gains of the low noise amplifier and the in-phase and quadrature-phase amplifiers. The automatic gain controller may supply a gain control signal to the low noise amplifier and the in-phase and quadrature-phase amplifiers according to the magnitude of the RF signal. The gain control signal may be controlled by a null control signal based on a null signal comprised in the RF signal.

Consistent with the embodiment of the present invention, the null control signal may control the gain control signal to have a consistent signal level at a null signal section of the RF signal.

Consistent with the embodiment of the present invention, the signal level may be a signal level of the gain control signal before the null signal is received.

Consistent with the embodiment of the present invention, the direction down-converter and the intermediate up-converter may be implemented in one chip by being integrated on a single material.

### BRIEF DESCRIPTION OF THE DRAWINGS

The invention will be described in detail with reference to the following drawings in which like numerals refer to like elements.

FIG. 1a illustrates a double conversion receiver comprising a direct down-converter that down converts a RF signal at a RF band into a zero-IF signal at a zero-IF band and outputs the zero-IF signal and an intermediate up-converter that up converts the down-converted zero-IF signal into a low-IF signal at a low-IF band and outputs the low-IF signal according to a first embodiment of the present invention;

FIG. 1b illustrates another exemplary double conversion receiver modified from the first embodiment of the present invention;

FIG. 2a illustrates a double conversion receiver comprising a direct down-converter that down converts a RF signal at a RF band into zero-IF signals each at a zero-IF band and outputs the zero-IF signals and an intermediate up-converter that up converts the down-converted zero-IF signals into a low-IF signal at a low-IF band and outputs the low-IF signal according to a second embodiment of the present invention;

FIG. 2b illustrates another exemplary double conversion receiver modified from the second embodiment of the present invention;

FIG. 3 illustrates a double conversion receiver comprising a direct down-converter that down converts a first RF signal at a first RF band and a second RF signal at a second RF band into a zero-IF signal at a zero-IF band and outputs the zero-IF signal and an intermediate up-converter that up converts the down-converted zero-IF signal into a low-IF signal at a low-IF band and outputs the low-IF signal; and

FIG. 4 illustrates a RF signal and a null control signal each comprising a null section in a double conversion receiver according to an embodiment of the present invention.

### DETAILED DESCRIPTION OF EMBODIMENTS

Various embodiments of the present invention will be described in a more detailed manner with reference to the drawings.

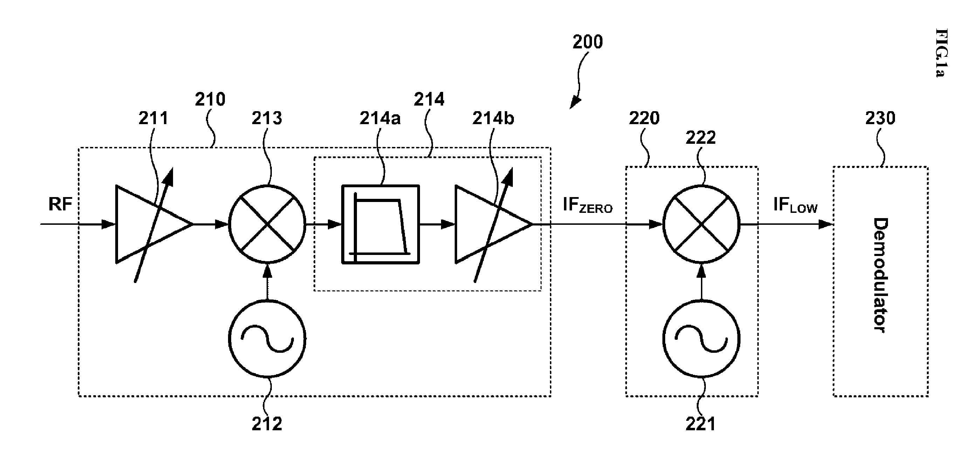

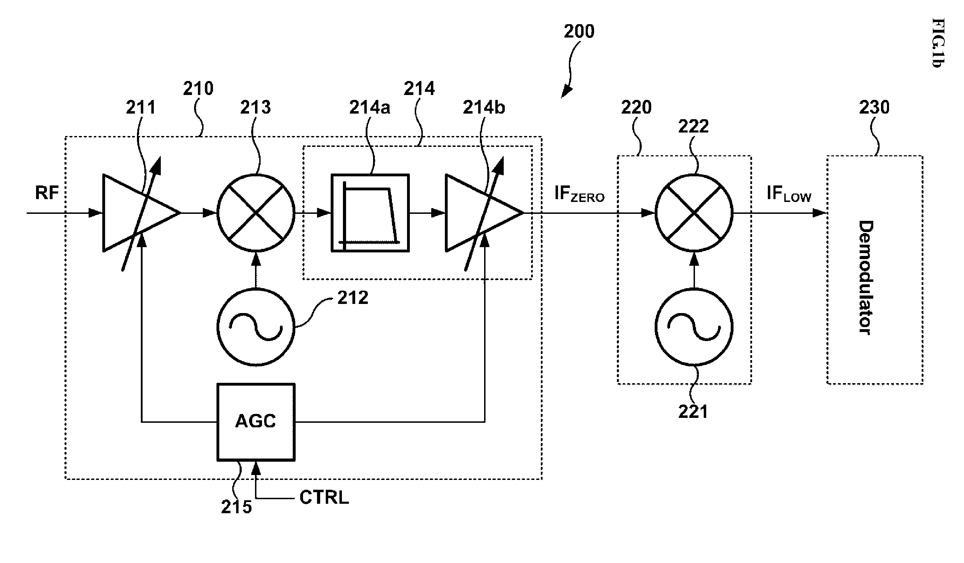

FIG. 1a illustrates a double conversion receiver 200 according to a first embodiment of the present invention. FIG. 1b illustrates another exemplary double conversion receiver modified from the double conversion receiver 200 according to the first embodiment of the present invention.

As illustrated in FIG. 1a, the double conversion receiver 200 comprises a direct down-converter 210 and an intermediate up-converter 220. The direct down-converter 210 down converts a RF signal RF at a RF band into a zero-IF signal IF_{ZERO} at a zero-IF band and outputs the zero-IF signal IF_{ZERO}. The intermediate up-converter 220 up converts the down-converted zero-IF signal IF_{ZERO} into a low-IF signal IF_{LOW} at a low-IF band and outputs the low-IF signal IF_{LOW}.

Configuration of the double conversion receiver 200 according to the first embodiment will be described hereinafter.

The direct down-converter 210 comprises a low noise amplifier 211, a down-frequency oscillator 212, a down-conversion mixer 213, and a filter 214. The filter 214 may comprise a low pass filter 214a and a variable gain amplifier 214b. The intermediate up-converter 220 comprises an up-frequency oscillator 221 and an up-conversion mixer 222.

The above elements of the double conversion receiver 200 according to the first embodiment of the present invention are coupled with each other as in the following.

An output terminal of the low noise amplifier 211 is coupled to a first input terminal of the down-conversion mixer 213. An output terminal of the down-frequency oscillator 212 is coupled to a second input terminal of the down-conversion mixer 213. An output terminal of the down-conversion mixer 213 is coupled to an input terminal of the low pass filter 214a. An output terminal of the low pass filter 214a is coupled to an input terminal of the variable gain amplifier 214b.

An output terminal of the variable gain amplifier 214b is coupled to a first input terminal of the up-conversion mixer 222. An output terminal of the up-frequency oscillator 221 is coupled to a second input terminal of the up-conversion mixer 222. An output terminal of the up-conversion mixer 222 is coupled to an input terminal of a demodulator 230.

Operation of the double conversion receiver 200 will be described below.

The low noise amplifier 211 receives the RF signal RF, and suppresses a noise signal and amplifies the RF signal RF. The low noise amplifier 211 has a structure that can adjust a gain.

The down-conversion mixer 213 receives a frequency signal oscillating at the down-frequency oscillator 212 and the amplified RF signal at the low noise amplifier 211, and down converts the amplified RF signal into a zero-IF signal at a zero-IF band. The down-frequency oscillator 212 generates a frequency for the down-conversion.

The low pass filter 214a filters a low frequency band of the zero-IF signal whose frequency band is down converted into the zero-IF band at the down-conversion mixer 213. The variable gain amplifier 214b receives the filtered zero-IF signal at the low pass filter 214a and amplifies the filtered zero-IF signal. The amplified zero-IF signal is labeled as "IF_{ZERO}". The variable gain amplifier 214b has a structure that can adjust a gain and performs variable amplification.

The up-conversion mixer 222 receives a frequency oscillating at the up-frequency oscillator 221 and the amplified zero-IF signal IF_{ZERO} at the variable amplifier 214b, and up converts the amplified zero-IF signal IF_{ZERO} into a low-IF signal IF_{LOW} at a low-IF band. The up-frequency oscillator 221 generates a frequency for the up-conversion.

On the basis of the above described structural configuration, the direct down-converter 210 of the double conversion receiver 200 down converts the RF signal RF at the RF band into the zero-IF signal IF_{ZERO} at the zero-IF band, and the intermediate up-converter 220 converts the down-converted zero-IF signal IF_{ZERO} into the low-IF signal IF_{LOW} at the low-IF band.

Therefore, the double conversion receiver 200 according to the first embodiment of the present invention can be improved in selection of a channel since the low pass filter 214a can be easily designed when a high value of adjacent channel rejection (ACR) is required between adjacent channels for the channel selection.

Thus, the low pass filter 214a can be manufactured without degrading performance of the double conversion receiver 200. Also, the typical SAW filter does not need to be installed outside. Accordingly, the double conversion receiver 200 can be manufactured at low cost, and the overall size of the double conversion receiver 200 decreases. As a result, the double conversion receiver 200 can be readily integrated on a single chip.

The demodulator 230 has a predetermined input frequency band. When designing a receiver, an input frequency or frequency of the demodulator 230 needs to be compatible with the predetermined input frequency band.

However, according to the first embodiment of the present invention, the intermediate up-converter 220 of the double conversion receiver 200 up converts the zero-IF signal IF_{ZERO} at the zero-IF band into the low-IF signal IF_{LOW} at the low-IF band. Thus, even if a frequency at any frequency band is input to the demodulator 230, a frequency of the output terminal of the double conversion receiver 200 can be easily changed. Hence, the double conversion receiver 200 can easily make interface with the demodulator 230.

For a signal at a certain frequency band, an information contained signal section is not often consecutive, and an information contained section and a null section that does not contain information usually coexist. Since the magnitude of the signal at the null section is usually less than that at the information contained section, the amplification gain of the low noise amplifier 211 or the variable gain amplifier 214b increases at the null section. The increasing amplification gain is often maintained even at the information contained section after the null section. As a result, an appropriate level of the amplification is not often achieved due to the maintenance of the large amplification gain.

To overcome this disadvantage, as illustrated in FIG. 1b, the double conversion receiver 200 according to the first embodiment is modified by additionally placing a gain controller 215 (e.g., an automatic gain controller (AGC)).

The gain controller 215 supplies a gain control signal to the low noise amplifier 211 or the variable gain amplifier 214b. The gain control signal is used to maintain the gain of the low noise amplifier 211 or the variable gain amplifier 214b according to the magnitude of the RF signal input to the modified double conversion receiver 200 in FIG. 1b.

The gain control signal is controlled by a null control signal CTRL according to a null section of the RF signal RF input to the modified double conversion receiver 200 in FIG.1b.

That is, the null control signal CTRL controls the gain control signal based on the null section, and controls the gain of the low noise amplifier 211 or the variable gain amplifier 214b according to the magnitude of the gain control signal.

Although the null control signal CTRL is illustrated in being input from outside of the modified double conversion receiver 200 in FIG. 1b, the null control signal CTRL can also be generated inside of the modified double conversion receiver 200 in FIG. 1b.

Due to the gain control signal and the null control signal CTRL, the gain of the low noise amplifier 211 or the variable gain amplifier 214b can be maintained at a consistent level. Therefore, while a null signal is received, the null control signal CTRL controls the amplification gain of the low noise amplifier 211 or the variable gain amplifier 214b not to increase to an abnormal level at the null section. In detail, the null control signal CTRL stops the amplification gain control for the low noise amplifier 211 or the variable gain amplifier 214b by the gain controller 215 of the modified double conversion receiver 200 in FIG. 1b, or maintains the gain control signal or the gain control signal before the null symbol is received at a consistent level.

In short, the null control signal CTRL can control the gain control signal not to increase abnormally by stopping the amplification gain control triggered by the gain control signal at the null section or maintaining a predetermined gain control signal or a gain control signal prior to receiving the null symbol at a consistent level.

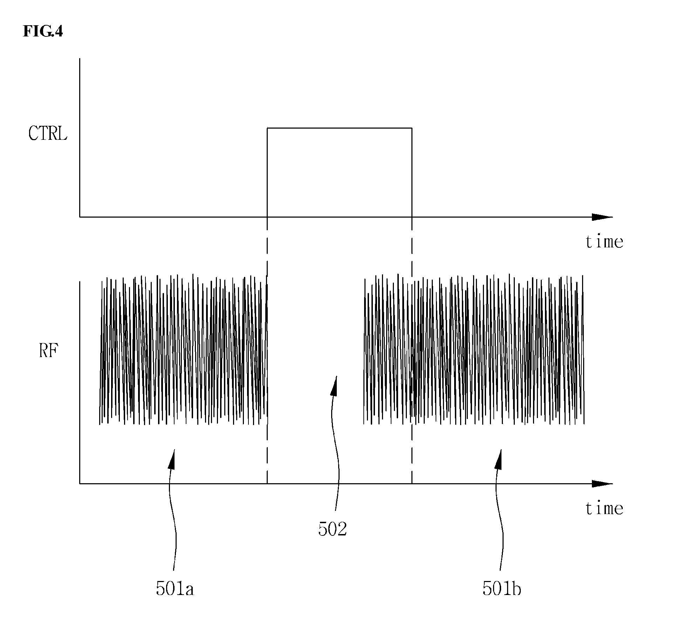

The null control signal CTRL will be described in detail with reference to FIG. 4 later.

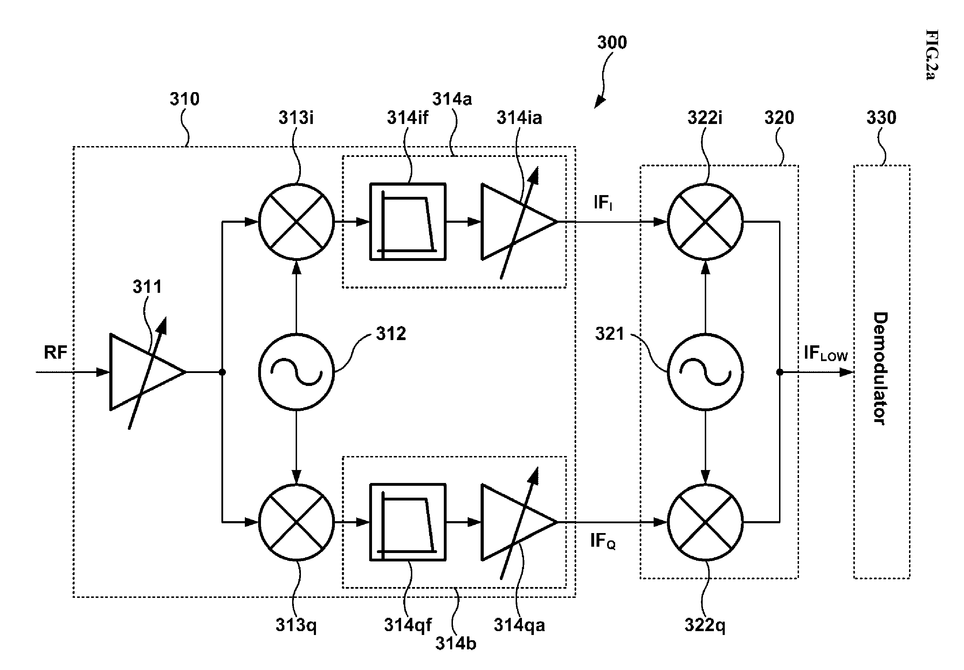

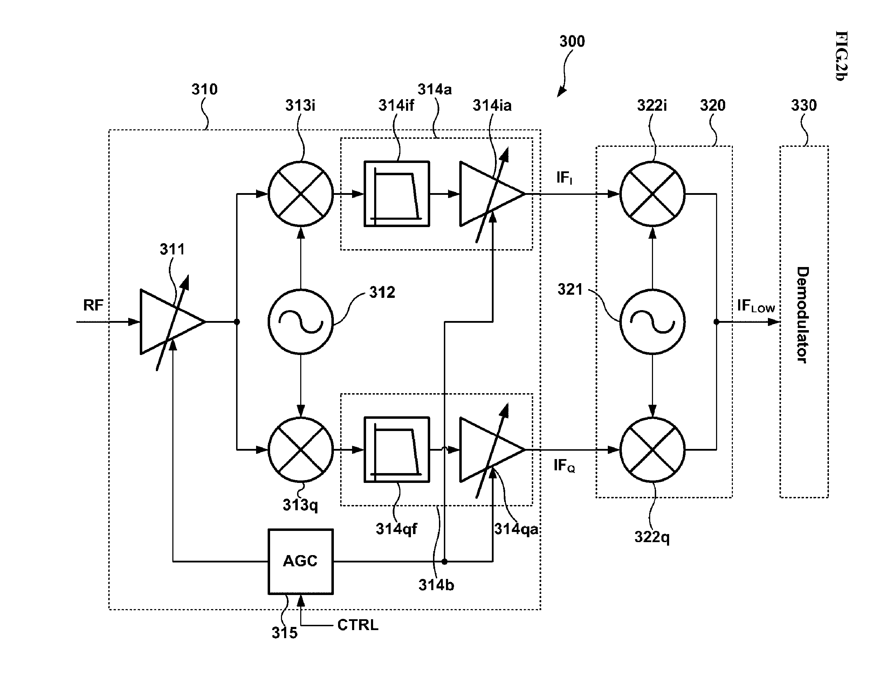

FIG. 2a illustrates a double conversion receiver 300 according to a second embodiment of the present invention. FIG. 2b illustrates another exemplary double conversion receiver modified from the double conversion receiver 300 according to the second embodiment of the present invention.

Referring to FIG. 2a, the double conversion receiver 300 comprises a direct down-converter 310 and an intermediate up-converter 320. The direct down-converter down converts a RF signal RF at a RF band into zero-IF signals IF_{I} and IF_{Q} each at a zero-IF band and outputs the zero-IF signals IF_{I} and IF_{Q}. The intermediate up-converter 320 up converts the down-converted zero-IF signals IF_{I} and IF_{Q} into a low-IF signal IF_{LOW} at a low-IF band and outputs the low-IF signal IF_{LOW}.

Configuration of the double conversion receiver 300 according to the second embodiment of the present invention is as follows.

The direct down-converter 310 comprises a low noise amplifier 311, an in-phase down-conversion mixer 313i, a quadrature-phase down-conversion mixer 313q, an in-phase filter 314a, a quadrature-phase filter 314b, and a down-frequency oscillator 312.

The in-phase filter 314a may comprise an in-phase low pass filter 314if and an in-phase amplifier 314ia. The quadrature-phase filter 314b may comprise a quadrature-phase low pass filter 314qf and a quadrature-phase amplifier 314qa.

The intermediate up-converter 320 comprises an up-frequency oscillator 321, an in-phase up-conversion mixer 322i and a quadrature-phase up-conversion mixer 322q.

The double conversion receiver 300 further comprises a demodulator 330 receiving an output of the intermediate up-converter 320.

The above described elements of the double conversion receiver 300 according to the second embodiment are coupled with each other as in the following.

An output terminal of the low noise amplifier 311 is coupled individually to a first input terminal of the in-phase down-conversion mixer 313i and a first input terminal of the quadrature down-conversion mixer 313q.

A second input terminal of the in-phase down-conversion mixer 313i is coupled to an in-phase frequency output terminal of the down-frequency oscillator 312. A second input terminal of the quadrature down-conversion mixer 313q is coupled to a quadrature-phase frequency output terminal of the down-frequency oscillator 312. An output terminal of the in-phase down-conversion mixer 313i is coupled to an input terminal of the in-phase low pass filter 314if. An output terminal of the quadrature-phase down-conversion mixer 313q is coupled to an input terminal of the quadrature-phase low pass filter 314qf.

An output terminal of the in-phase low pass filter 314if is coupled to an input terminal of the in-phase amplifier 314ia. An output terminal of the quadrature-phase low pass filter 314qf is coupled to an input terminal of the quadrature-phase amplifier 314qa.

An output terminal of the in-phase amplifier 314ia is coupled to a first input terminal of the in-phase up-conversion mixer 322i. An output terminal of the quadrature-phase amplifier 314qa is coupled to a first input terminal of the in-phase up-conversion mixer 322q.

A second input terminal of the in-phase up-conversion mixer 322i is coupled to an in-phase frequency output terminal of the up-frequency oscillator 312. A second input terminal of the quadrature-phase up-conversion mixer 322q is coupled to a quadrature-phase frequency output terminal of the up-frequency oscillator 312. An output terminal of the in-phase up-conversion mixer 322i and an output terminal of the quadrature-phase up-conversion mixer 322q are coupled commonly to an input terminal of the demodulator 330.

The double conversion receiver 300 operates as follows.

The low noise amplifier 311 receives a RF signal RF, and suppresses a noise signal and amplifies the RF signal RF. The low noise amplifier 311 has a structure that can adjust a gain.

The in-phase down-conversion mixer 313i receives a down-frequency oscillating from the down-frequency oscillator 312 and the amplified RF signal at the low noise amplifier 311, and down converts the amplified RF signal into a zero-IF signal at a zero-IF band of an I-channel. The quadrature-phase down-conversion mixer 313q receives a down-frequency oscillating from the down-frequency oscillator 312 and the amplified RF signal at the low noise amplifier 311, and down converts the amplified RF signal into a zero-IF signal at a zero-IF band of a Q-channel.

The down-frequency oscillator 312 generates an in-phase frequency and a quadrature-phase frequency for the down-conversion.

The in-phase low pass filter 314if filters a low frequency band of the down-converted zero-IF signal of the I-channel. The quadrature-phase low pass filter 314qf filters a low frequency band of the down-converted zero-IF signal of the Q-channel.

The in-phase amplifier 314ia receives the zero-IF signal of the I-channel filtered at the in-phase low pass filter 314if and amplifies the filtered zero-IF signal of the I-channel. The amplified zero-IF signal of the I-channel is labeled as "IF_{I}·" The in-phase amplifier 314ia has a structure that can adjust a gain. The quadrature-phase amplifier 314qa receives the zero-IF signal of the Q-channel filtered at the quadrature-phase low pass filter 314qf and amplifies the filtered zero-IF signal of the Q-channel. The amplified zero-IF signal of the Q-channel is labeled as "IF_{Q}." The quadrature-phase amplifier 314qa has a structure that can adjust a gain.

The in-phase up-conversion mixer 322i receives an up-frequency oscillating from the up-frequency oscillator 321 and the amplified zero-IF signal IF_{I} at the in-phase amplifier 314ia, and up converts the amplified RF signal IF_{I} into a low-IF signal at a low-IF band IF_{LOW}. The quadrature-phase up-conversion mixer 322q receives an up-frequency oscillating from the up-frequency oscillator 321 and the amplified zero-IF signal IF_{Q} at the quadrature-phase low noise amplifier 314qa, and up converts the amplified zero-IF signal IF_{Q} into a low-IF signal IF_{LOW} at the low-IF band.

The up-frequency oscillator 321 generates an in-phase frequency and a quadrature-phase frequency for the up-conversion.

On the basis of the above described structural configuration, the direct down-converter 310 of the double conversion receiver 300 down converts the RF signal RF at the RF band into the zero-IF signals IFI and IF_{Q} each at the zero-IF band, and the intermediate up-converter 320 converts the down-converted zero-IF signals IF_{I} and IF_{Q} into the low-IF signal IF_{LOW} at the low-IF band.

Therefore, the double conversion receiver 300 according to the second embodiment of the present invention can be improved in selection of a channel since the in-phase and quadrature-phase low pass filters 314i and 314q can be easily designed when a high value of ACR is required between adjacent channels for the channel selection.

Thus, the in-phase and quadrature-phase low pass filters 314i and 314q can be manufactured without degrading performance of the double conversion receiver 300. Also, the typical SAW filter does not need to be installed outside. Accordingly, the double conversion receiver 300 can be manufactured at low cost, and the overall size of the double conversion receiver 300 decreases. As a result, the double conversion receiver 300 can be readily integrated on a single chip.

The demodulator 330 has a predetermined input frequency band. When designing a receiver, an input frequency or frequency of the demodulator 330 needs to be compatible with the predetermined input frequency band.

However, according to the second embodiment of the present invention, the intermediate up-converter 320 of the double conversion receiver 300 up converts the zero-IF signals IF_{I} and IF_{Q} each at the zero-IF band into the low-IF signal IF_{LOW} at the low-IF band. Thus, even if a frequency at any frequency band is input to the demodulator 330, a frequency of the output terminal of the double conversion receiver 300 can be easily changed. Hence, the double conversion receiver 300 can easily make interface with the demodulator 330.

For a signal at a certain frequency band, an information contained signal section is not often consecutive, and an information contained section and a null section that does not contain information usually coexist. Since the magnitude of the signal at the null section is usually less than that at the information contained section, the amplification gain of the low noise amplifier 311 or the in-phase or quadrature-phase amplifier 314ia and 314qa increases at the null section. The increasing amplification gain is often maintained even at the information contained section after the null section. As a result, an appropriate level of the amplification is not often achieved due to the maintenance of the large amplification gain.

To overcome this disadvantage, as illustrated in FIG. 2b, the double conversion receiver 300 according to the second embodiment is modified by additionally placing a gain controller 315 (e.g., an AGC).

The gain controller 315 supplies a gain control signal to the low noise amplifier 311 or the in-phase or quadrature-phase amplifier 314ia and 314qa. The gain control signal is used to maintain the gain of the low noise amplifier 311 or the in-phase or quadrature-phase amplifier 314ia and 314qa according to the magnitude of the RF signal input to the modified double conversion receiver 300 in FIG. 2b.

The gain control signal is controlled by a null control signal CTRL according to a null section of the RF signal RF input to the modified double conversion receiver 300 in FIG. 2b. That is, the null control signal CTRL controls the gain control signal based on the null section, and controls the gain of the low noise amplifier 311 or the in-phase or quadrature-phase amplifier 314ia and 314qa according to the magnitude of the gain control signal.

Although the null control signal CTRL is illustrated in being input from outside of the modified double conversion receiver 300 in FIG. 2b, the null control signal CTRL can also be generated inside of the modified double conversion receiver 300 in FIG. 2b.

Due to the gain control signal and the null control signal CTRL, the gain of the low noise amplifier 311 or the in-phase or quadrature-phase amplifier 314ia and 314qa can be maintained at a consistent level. Therefore, while a null signal is received, the null control signal CTRL controls the amplification gain of the low noise amplifier 311 or the in-phase or quadrature-phase amplifier 314ia and 314qa not to increase to an abnormal level at the null section. In detail, the null control signal CTRL stops the amplification gain control for the low noise amplifier 311 or the in-phase or quadrature-phase amplifier 314ia and 314qa by the gain controller 315 of the modified double conversion receiver 300 in FIG. 2b, or maintains the gain control signal or the gain control signal before the null symbol is received at a consistent level.

In short, the null control signal CTRL can control the gain control signal not to increase abnormally by stopping the amplification gain control triggered by the gain control signal at the null section or maintaining a predetermined gain control signal or a gain control signal prior to receiving the null symbol at a consistent level.

The null control signal CTRL will be described in detail with reference to FIG. 4 later.

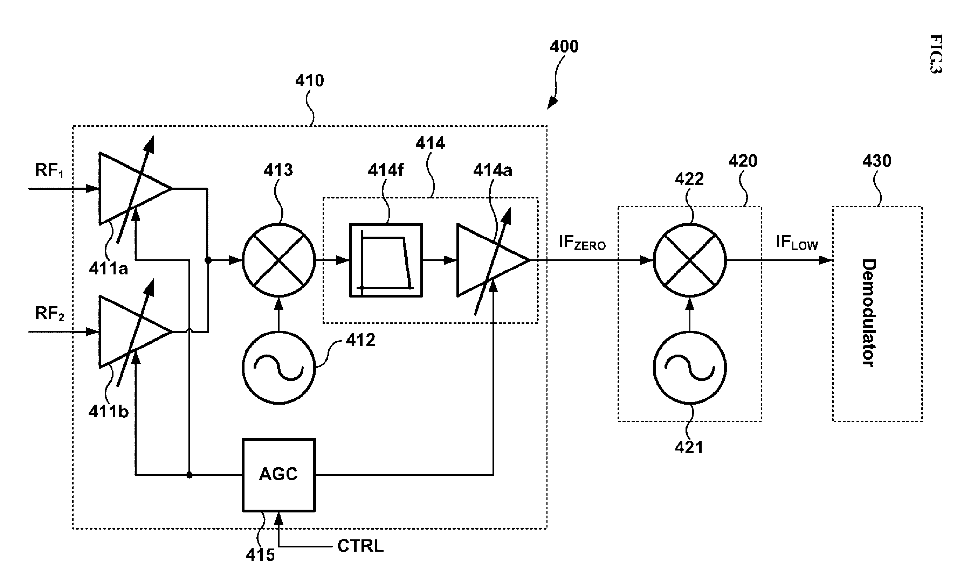

FIG. 3 illustrates a double conversion receiver 400 acocridng to a third embodiment of the present invention.

The double conversion receiver 400 comprises a direct down-converter 410 and an intermediate up-converter 420. The direct down-converter 410 down converts a first RF signal RF₁ at a first RF band and a second RF signal RF₂ at a second RF band into a zero-IF signal IF_{ZERO} at a zero-IF band and outputs the zero-IF signal IF_{ZERO}. The intermediate up-converter 420 up converts the down-converted zero-IF signal IF_{ZERO} into a low-IF signal IF_{LOW} at a low-IF band and outputs the low-IF signal IF_{LOW}.

The double conversion receiver 400 is configured as follows.

The direct down-converter 410 comprises a first low noise amplifier 411a, a second low noise amplifier 411b, a down-frequency oscillator 412, a down-conversion mixer 413, and a filter 414. The filter 414 may comprise a low pass filter 414f and a variable gain amplifier 414a. The intermediate up-converter 420 comprises an up-frequency oscillator 421 and an up-conversion mixer 422.

The above described elements of the double conversion receiver 400 are coupled with each other as follows.

An output terminal of the first low noise amplifier 411a and an output terminal of the second low noise amplifier 411b are coupled commonly to a first input terminal of the down-conversion mixer 413. An output terminal of the down-frequency oscillator 412 is coupled to a second input terminal of the down-conversion mixer 413. An output terminal of the down-conversion mixer 413 is coupled to an input terminal of the low pass filter 414f. An output terminal of the loss pass filter 414f is coupled to an input terminal of the variable gain amplifier 414a.

A null control signal CTRL is supplied to an input terminal of a gain controller 415 (e.g., an AGC). A RF gain control output terminal of the gain controller 415 is coupled to a control terminal of the first low noise amplifier 411a or the second low noise amplifier 411b, and an IF gain control output terminal of the gain controller 415 is coupled to a control terminal of the variable gain amplifier 414a. An output terminal of the variable gain controller 414a is coupled to a first input terminal of the up-conversion mixer 422. An output terminal of the up-frequency oscillator 421 is coupled to a second input terminal of the up-conversion mixer 422. An output terminal of the up-conversion mixer 422 is coupled to an input terminal of a demodulator 430.

Operation of the double conversion receiver 400 will be described hereinafter.

The first low noise amplifier 411a receives the first RF signal RF₁, and suppresses a noise signal and amplifies the first RF signal RF₁ at a first band. The second low noise amplifier 411b receives the second RF signal RF₂, and suppresses a noise signal and amplifies the second RF signal RF₂ at a second band. Each of the first and second low noise amplifiers 411a and 411b has a structure that can adjust a gain.

The down-conversion mixer 413 receives a frequency oscillating at the down-frequency oscillator 412 and the first or second RF signal RF₁ or RF₂ amplified at the first or second low noise amplifier 411a or 411b. The down-conversion mixer 413 removes an image frequency component from the received first or second RF signal RF₁ or RF₂, and down converts the first or second RF signal RF₁ or RF₂ into a zero-IF signal at a zero-IF band. The down-frequency oscillator 412 generates a frequency for the down-conversion.

The low pass filter 414f filters a frequency band of the down-converted zero-IF signal. The variable gain amplifier 414a receives the zero-IF signal filtered at the loss pass filter 414f and amplifies the filtered zero-IF signal. The amplified zero-IF signal at the variable gain amplifier 414a is labeled as "IF_{ZERO}." The variable gain amplifier 414a has a structure that allows the gain adjustment as simultaneously as the variable amplification.

For a signal at a certain frequency band, an information contained signal section is not often consecutive, and an information contained section and a null section that does not contain information usually coexist. The gain controller 415 supplies a gain control signal to the first or second low noise amplifier 411a or 411b or the variable gain amplifier 414a. The gain control signal is used to maintain the gain of the first or second low noise amplifier 411a or 411b or the variable gain amplifier 414a according to the magnitude of the first or second RF signal RF₁ or RF₂ input to the double conversion receiver 400. The gain control signal is controlled by a null control signal CTRL according to a null section of the first or second RF signal RF₁ or RF₂ input to the double conversion receiver 400. That is, the null control signal CTRL controls the gain control signal based on the null section, and controls the gain of the first or second low noise amplifier 411 a or 411b or the variable gain amplifier 414a according to the magnitude of the gain control signal. Although the null control signal CTRL is illustrated in being input from outside of the double conversion receiver 400, the null control signal CTRL can also be generated inside of the double conversion receiver 400.

Due to the gain control signal and the null control signal CTRL, the gain of the first or second low noise amplifier 411a or 411b or the variable gain amplifier 414a can be maintained at a consistent level. Therefore, while a null signal is received, the null control signal CTRL controls the amplification gain of the first or second low noise amplifier 411a or 411b or the variable gain amplifier 414a not to increase to an abnormal level at the null section. In detail, the null control signal CTRL stops the amplification gain control for the first or second low noise amplifier 411a or 411b or the variable gain amplifier 414a by the gain controller 415 of the double conversion receiver 400, or maintains the gain control signal or the gain control signal before the null symbol is received at a consistent level.

In short, the null control signal CTRL can control the gain control signal not to increase abnormally by stopping the amplification gain control triggered by the gain control signal at the null section or maintaining a predetermined gain control signal or a gain control signal prior to receiving the null symbol at a consistent level.

The null control signal CTRL will be described in detail with reference to FIG. 4 later.

The up-conversion mixer 422 receives a frequency oscillating at the up-frequency oscillator 421 and the amplified zero-IF signal IF_{ZERO} and up converts the amplified zero-IF signal IFZERO into a low-IF signal IF_{LOW} at a low-IF band. The up-frequency oscillator 421 generates a frequency for the up-conversion.

The low-IF signal IF_{LOW} output from the up-conversion mixer 422 is a signal with a wide range of frequencies. For instance, the low-IF signal IFLOW has a center frequency of approximately 850 KHz, 2.048 MHz or 38.912 MHz.

On the basis of the above described structural configuration, the direct down-converter 410 of the double conversion receiver 400 down converts the first or second RF signal RF₁ or RF₂ each at the RF band into the zero-IF signal IF_{ZERO} at the zero-IF band, and the intermediate up-converter 420 converts the down-converted zero-IF signal IF_{ZERO} into the low-IF signal IF_{LOW} at the low-IF band.

Therefore, the double conversion receiver 400 according to the third embodiment of the present invention can be improved in selection of a channel since the low pass filter 414f can be easily designed when a high value of ACR is required between adjacent channels for the channel selection. Thus, the low pass filter 414f can be manufactured without degrading performance of the double conversion receiver 400. Also, the typical SAW filter does not need to be installed outside. Accordingly, the double conversion receiver 400 can be manufactured at low cost, and the overall size of the double conversion receiver 400 decreases. As a result, the double conversion receiver 400 can be readily integrated on a single chip.

The demodulator 430 has a predetermined input frequency band. When designing a receiver, an input frequency or frequency of the demodulator 430 needs to be compatible with the predetermined input frequency band.

However, according to the third embodiment of the present invention, the intermediate up-converter 420 of the double conversion receiver 400 up converts the zero-IF signal IF_{ZERO} at the zero-IF band into the low-IF signal IF_{LOW} at the low-IF band. Thus, even if a frequency at any frequency band is input to the demodulator 430, a frequency of the output terminal of the double conversion receiver 400 can be easily changed. Hence, the double conversion receiver 400 can easily make interface with the demodulator 430. Accordingly, the double conversion receiver 400 can interface with any demodulator that uses a wide range of the IF band.

FIG. 4 illustrates a RF signal RF and a null control signal CTRL each comprising a null section in the double conversion receiver 200, 300 or 400 according to an embodiment of the present invention.

FIG. 4 is to describe the embodiments of the present invention illustrated in FIGS. 1a to 3, and can be commonly applied to the embodiments illustrated in FIGS. 1A to 3.

In the following descriptions, the embodiment of the present invention illustrated in FIG. 1a is used as a reference.

The RF signal received at the double conversion receiver comprises information sections 501a and 501b and a null section 502.

Depending on the intensity of the received RF signal, the gain control signal that controls the amplification gain of the low noise amplifier 211 and the variable gain amplifier 214b is supplied to the low noise amplifier 211 and the variable gain amplifier 214b. Based on the null signal that the received RF signal comprises, the null control signal CTRL controls the gain control signal, which is supplied to the low noise amplifier 211 and the variable gain amplifier 214b as described above. The null control signal CTRL may be provided internally or externally.

The null control signal CTRL turns on at a range between before and after the beginning of the null section 502. In contrast, the null control signal CTRL turns off at a range between before and after the ending of the null section 502.

The null control signal CTRL controlling the gain control signal can also be controlled by other various methods instead of the above turning-on and turning-off method. If the null control signal CTRL turns on before the information section 501a or 501b ends, the null control signal CTRL stops the amplification gain control performed according to the gain control signal or controls the gain control signal to become a predetermined gain control signal.

The null control signal CTRL maintains the gain control signal at a predetermined, consistent signal level. The predetermined, consistent signal level may be a signal level of the gain control signal before the information section 501a or 501b ends. Due to the control of the gain control signal by the null control signal CTRL, an abnormal increase in the amplification gain at the null section 502 can be reduced.

According to various embodiments, the double conversion receiver can easily select a channel without using the typical SAW filter, be miniaturized, consume less power, and make interface at various ranges of standard frequency bands.

Also, the double conversion receiver can maintain the received RF signal at a consistent level.

The invention being thus described, it will be obvious that the same may be varied in many ways. Such variations are not to be regarded as a departure from the spirit and scope of the invention and all such modifications as would be obvious to one skilled in the art are intended to be included within the scope of the following claims.

## Claims

1. A double conversion receiver comprising:
a direct down-converter down converting a radio frequency (RF) signal at a RF band into a zero-intermediate frequency (IF) signal at a zero-IF band; and
an intermediate up-converter up converting the down-converted zero-IF signal into a low-IF signal at a low-IF band.

2. The double conversion receiver of claim 1, wherein the direct down-converter comprises:
a low noise amplifier amplifying the RF signal;
a down-conversion mixer down converting the amplified RF signal into a zero-IF signal at a zero-IF band;
a down-frequency oscillator generating a frequency for the down-conversion and supplying the frequency to the down-conversion mixer; and
a filter filtering the zero-IF signal output from the down-conversion mixer,
wherein the intermediate up-converter comprises:
an up-conversion mixer up converting the zero-IF signal output from the filter into the low-IF signal at the low-IF band; and
an up-frequency oscillator generating a frequency for the up-conversion and providing the frequency to the up-conversion mixer.

3. The double conversion receiver of claim 2, wherein the filter comprises:
a low pass filter filtering a low frequency band of the zero-IF signal output from the down-conversion mixer; and
a variable gain amplifier amplifying the zero-IF signal output from the low pass filter.

4. The double conversion receiver of claim 2, further comprising an automatic gain controller controlling amplification gains of the low noise amplifier and the variable gain amplifier, wherein the automatic gain controller supplies a gain control signal to the low noise amplifier and the variable gain amplifier according to the magnitude of the RF signal, wherein the gain control signal is controlled by a null control signal based on a null signal comprised in the RF signal.

5. The double conversion receiver of claim 4, wherein the null control signal controls the gain control signal to have a consistent signal level at a null signal section of the RF signal.

6. The double conversion receiver of claim 5, wherein the signal level is a signal level of the gain control signal before the null signal is received.

7. The double conversion receiver of claim 1, wherein the direct down-converter comprises:
a low noise amplifier amplifying the RF signal;
an in-phase down-conversion mixer down converting the amplified RF signal into a zero-IF signal at a zero-IF band of an 1-channel;
a quadrature-phase down-conversion mixer down converting the amplified RF signal into a zero-IF signal at a zero-IF band of a Q-channel;
a down-frequency oscillator generating an in-phase frequency and a quadrature-phase frequency for the down-conversion and supplying the in-phase frequency and the quadrature-phase frequency to the in-phase down-conversion mixer and the quadrature-phase down-conversion mixer, respectively;
an in-phase filter filtering the in-phase zero-IF signal at the zero-IF band of the I-channel output from the in-phase down-conversion mixer; and
a quadrature-phase filter filtering the quadrature-phase zero-IF signal at the zero-IF band of the Q-channel output from the quadrature-phase down-conversion mixer,
wherein the intermediate up-converter comprises:
an in-phase up-conversion mixer up converting the filtered in-phase zero-IF signal at the zero-IF band of the I-channel into the low-IF signal at the low-IF band;
a quadrature-phase up-conversion mixer up converting the filtered quadrature-phase zero-IF signal at the zero-IF band of the Q-channel into the low-IF signal at the low-IF band; and
an up-frequency oscillator generating a frequency for the up-conversion and supplying the frequency to the up-conversion mixer.

8. The double conversion receiver of claim 7, wherein the in-phase filter comprises:
an in-phase low pass filter filtering a low frequency band of the zero-IF signal output from the in-phase down-conversion mixer; and
an in-phase amplifier amplifying the in-phase zero-IF signal output from the in-phase low pass filter,
wherein the quadrature-phase filter comprises:
a quadrature-phase low pass filter filtering a low frequency band of the zero-IF signal output from the quadrature-phase down-conversion mixer; and
a quadrature-phase amplifier amplifying the quadrature-phase zero-IF signal output from the quadrature-phase low pass filter.

9. The double conversion receiver of claim 8, further comprising an automatic gain controller controlling amplification gains of the low noise amplifier and the in-phase and quadrature-phase amplifiers, wherein the automatic gain controller supplies a gain control signal to the low noise amplifier and the in-phase and quadrature-phase amplifiers according to the magnitude of the RF signal, wherein the gain control signal is controlled by a null control signal based on a null signal comprised in the RF signal.

10. The double conversion receiver of claim 9, wherein the null control signal controls the gain control signal to have a consistent signal level at a null signal section of the RF signal.

11. The double conversion receiver of claim 10, wherein the signal level is a signal level of the gain control signal before the null signal is received.

12. The double conversion receiver of claim 1, wherein the direction down-converter and the intermediate up-converter are implemented in one chip by being integrated on a single material.
